# EUROPEAN PATENT APPLICATION

(11) **EP 4 531 107 A1**
(43) Date of publication of application: **02.04.2025**
(21) Application number: 23199995.4
(22) Date of filing: 27.09.2023
(51) Int. Cl.: H01L 29/06, H01L 29/78

(54) **IMPROVED TOP SURFACE OF A JUNCTION TERMINATION EXTENSION FOR SEMICONDUCTOR DEVICES**

(71) Applicant: Nexperia B.V., 6534 AB Nijmegen (NL)
(72) Inventor: Böttcher, Tim, 22529 Hamburg (DE); El-Zammar, Georgio, Hamburg (DE); Mazzillo, Massimo Cataldo, Hamburg (DE)
(74) Representative: Pjanovic, Ilija

(57) **Abstract**

The present disclosure presents a semiconductor device including a semiconductor body, wherein the semiconductor body includes one or more recessed regions in a P doped Junction Termination Extension, JTE, region, wherein a depth of the recessed regions is smaller than a depth of the JTE region, and an N+ implant at a top surface of the JTE region, such that the N+ implant forms a part of mesa regions in between the recessed regions. A method of manufacturing such semiconductor device is also presented.

## Description

### Technical field

The present disclosure relates to a method of manufacturing semiconductor device and a semiconductor device. More specifically the present disclosure is related to an improved top surface of a Junction Termination Extension (JTE) for semiconductor devices.

### Background

Most of planar and trench power devices are based of one or several n-type/p-type junctions. When the active part of the junction ends on the lateral side of the device, a very high electric field may appear under reverse voltage biasing due to junction curvature or trench corners.

A periphery protection, called edge termination may therefore be necessary. Edge termination is an important part of power devices. Passivation charges in the termination can result in reliability failures, low reverse blocking capability and poor Unclamped Inductive Switching (UIS) ruggedness.

Reliable and robust high voltage devices need effective edge termination structures to protect the device periphery, so that blocking values close to the ideal 1D avalanche voltage value can be achieved. Several physical limitations make, e.g., Silicon Carbide (SiC) edge terminations quite complex to design. The main limitation is the low diffusion coefficients of dopant atoms inside the semiconductor. Deep junctions (> 1µm) are difficult to implement, and lateral dopants diffusion is very limited. Moreover, the higher interface traps level observed in the SiC/passivation interface compared to Silicon is also affecting the efficiency of the standard Si terminations architectures in the SiC power devices. Charges may accumulate at the interface, generating breakdown voltage instabilities and early failures, especially with temperature.

In a bipolar transistor, there are parasitic components like the collector-base and emitter-base junction capacitances that can affect the transistor's high-frequency performance. The JTE technique involves intentionally adding a lightly doped region (typically a P-type region) near the collector or emitter junction to create a gradual transition between the highly doped region and the lightly doped region. This helps to reduce the capacitance at the junction, which in turn reduces the impact on the transistor's high-frequency response. Moreover, the JTE distributes the electric field laterally from active area to die edge in such a way, that the peak field may be minimized and no lateral or termination breakdown occurs. At the same time the termination should be robust against the movement or accumulation of charges under stress test or operation conditions.

One common termination design for SiC is the JTE. It may be used to reduce the impact of unwanted parasitic elements in the device structure and improve its performance. The breakdown voltage of the JTE region in a rectifier is highly sensitive to the doping concentration of the JTE (here but not limited to low p-type). This implies as well that the JTE termination is sensitive to charge accumulation in the region.

### Summary

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

The present disclosure aims to overcome the drawbacks identified in the background section. More specifically, the present disclosure aims to reduce the electrical field in the critical interface region between JTE and passivation stack.

Hereto, the present disclosure presents an "inverted" Kao ring structure in the JTE region, which may be created through an N+ area implant followed by a dry etch step. The distributed N+ Kao ring structure balances the charge in the termination and distributes the electric field, making it more robust against doping and charge variation. The Kao ring structure creation through a dry etch process allows very fine patterning without corner effects due to implant scattering.

According to an aspect of the present disclosure, a method of manufacturing a semiconductor device is presented. The method may include forming one or more recessed regions in a P doped Junction Termination Extension, JTE, implant of a semiconductor body. A depth of the recessed regions may be smaller than a depth of the JTE implant. The method may further include forming an N+ implant at a top surface of the JTE implant, such that the N+ implant forms a part of mesa regions in between the recessed regions.

In an embodiment, the depth of the recessed regions may be smaller than half of the depth of the JTE implant.

In an embodiment, the method may include forming the N+ implant by one of an ion implantation or during epitaxy.

In an embodiment, the method may include forming multiple N+ implants at the top surface of the JTE implant with decreasing doping from the top surface of the JTE implant downwards.

In an embodiment, the method may include forming the multiple N+ implants using multiple implantation steps with increasing dose and energy, producing a graded doping profile with the decreasing doping from the top surface of the JTE implant downwards.

In an embodiment, the multiple N+ implants may be two N+ implants.

In an embodiment, the method may include forming multiple recessed regions having a substantially constant width and a substantially constant spacing.

In an embodiment, the method may include forming multiple recessed regions having a spacing that increases along the JTE implant from an active area up to an outer edge of a termination.

In an embodiment, the method may include etching a further recessed region outside of the JTE implant and near a die edge. The further recessed region may be etched during the same process used for forming the recessed regions in the JTE.

In an embodiment, the method may include forming an N+ implant at a top of the further recessed region during the same process used for forming the N+ implant at the top of the JTE implant.

In an embodiment, the method may include forming P-compensation implants at a bottom of the recessed regions.

In an embodiment, the method may include forming a P+ implant at a top surface of the JTE implant and below the N+ implant. The P+ implant may form a part of the recessed regions.

According to an aspect of the present disclosure, a semiconductor device is presented. The semiconductor device may include a semiconductor body. The semiconductor body may include one or more recessed regions in a P doped Junction Termination Extension, JTE, region. A depth of the recessed regions may be smaller than a depth of the JTE region. The semiconductor body may further include an N+ implant at a top surface of the JTE region, such that the N+ implant forms a part of mesa regions in between the recessed regions.

In an embodiment, the semiconductor device may include multiple N+ implants at the top surface of the JTE implant with decreasing doping from the top surface of the JTE implant downwards.

In an embodiment, the semiconductor body may include P-compensation implants at a bottom of the recessed regions.

In an embodiment, the semiconductor body may include a P+ implant at a top surface of the JTE implant and below the N+ implant, such that the P+ implant forms a part of the recessed regions

In an embodiment, the semiconductor device may be created using a method having one or more of the above described features.

### Brief description of the Drawings

Embodiments of the present disclosure will now be described, by way of example only, with reference to the accompanying schematic drawings in which corresponding reference symbol indicate corresponding parts, in which:
Figs. 1-4 show cross-sectional side views of example embodiments of a semiconductor body;
Fig. 5 schematically shows a semiconductor device including a semiconductor body according to an example embodiment; and
Fig. 6 shows a flow chart of a method of an example embodiment.

The figures are intended for illustrative purposes only, and do not serve as restriction of the scope of the protection as laid down by the claims.

### Detailed description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the present disclosure is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure may be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

An improvement in termination behavior may be obtained by implanting the top surface of the JTE with counter doping (i.e., N+ doping vs. P- doping in JTE) and creating recessed regions by etching. Different recessed regions may have different geometry, i.e., different width and/or spacing, inside the JTE. As a result, the electrical field at the JTE surface may be reduced, and the lateral doping across the same termination may be modulated.

Further improvements in termination behavior may be obtained by including deeper N+ implantation, incorporation of P-compensation implant at the bottom of the recessed area and/or incorporation of P-compensation implant under the N+ regions with a purpose of avoiding the field penetration into the PN junction.

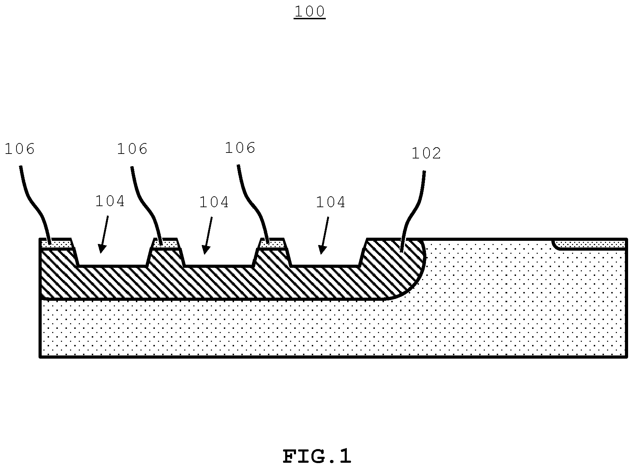

Fig. 1 shows an example embodiment of a semiconductor body 100, including a P type doped JTE 102 with recessed regions 104 and with an N+ implant 106 at the top surface. The N+ implant at the top surface of the JTE implant may thus form a part of mesa regions in between the recessed regions. The recessed regions 104 may be etched inside the JTE 102, e.g., using dry etching. The N+ layer 106 may be segmented by etching.

In an example, the P doped layer 102 may have a doping between 3E16cm-3 and 8E17cm-3, preferably 1E17cm-3, and a depth between 0.5um and 1.5um, preferably 1um.

In an example, the N+ regions 106 may have a doping between 1E18cm-3 and 1E20 cm-3, preferably 1E19 cm-3, and a depth between 0.1um and 0.3um, preferably 0.2um.

The recessed regions may have a depth lower than half of the JTE 102 depth, and preferably lower than 0.5um.

In the preferred embodiment, the recessed regions 104 have a constant width and spacing, e.g., a width in the range 0.5um-1.5um and a spacing of 3um-5um, preferably a pitch of 5um with 1 um width and 4 um spacing.

In another embodiment, the spacing between recessed regions is not constant and increases along the JTE 102 from the active area up to outer edge of the termination, for example of 50%.

In an example embodiment, the N+ layer 106 may be created by ion implantation. In another example embodiment, the N+ layer 106 may be created during epitaxy.

The semiconductor body 100 may include suitable passivation layers in the form of one single layer or a passivation stack including oxide based and nitride based dielectric layers (not shown in the figure). The passivation layers may cover the whole termination area.

The use of recessed regions 104 inside the JTE 102 in combination with shallow N+ implants 106 on the top surface enable reduction of the occurrence of single electric field peaks. The Kao ring structure makes that the electric field may be segmented and accordingly distributed along the JTE region 102. This advantageously reduces electrical field peaks at the JTE surface where interface states are present due to passivation layer deposition and/or other process steps (e.g. oxidation or etching). A high electrical field at the surface region with high density of interface states may trigger trapping or emission of carriers, resulting at the end in leakage increase and unstable termination behavior, due to an unbalanced working of the JTE, especially under high bias and temperature conditions.

Moreover, the use of etched regions with possibly different width and/or spacing allows to laterally modulate the JTE doping where the control of the doping along the termination region is defined by the geometry of the recessed regions. Advantageously, this allows for an improved and more flexible control of the lateral doping, compared to the use of standard, known implantation techniques.

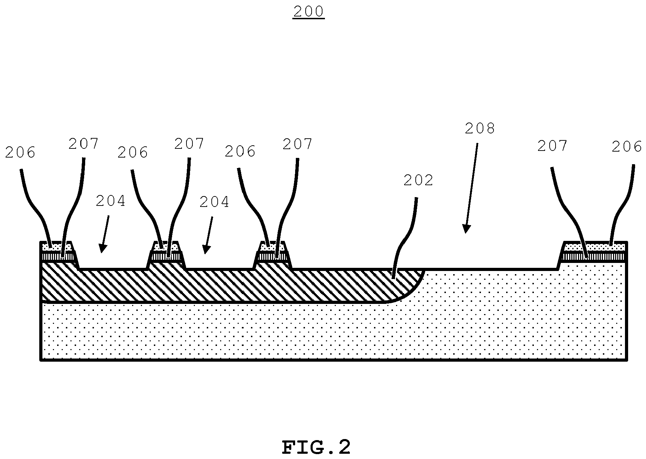

The N+ implant may be carried out during the same implantation step used to create the channel stopper region at the die edge, usually included at least in high voltage power devices. This may be realized by an extension of the outermost recessed region 208 to the channel stopper as illustrated in Fig. 2. Therefore, the semiconductor body 100 with improved working of the JTE can be obtained by using a device/process architecture with reduced technology complexity and production costs.

Fig. 2 shows an example embodiment of a semiconductor body 200, including a P type doped JTE 202 with recessed regions 204 and multiple N+ implants 206, 207 with increasing doping at the top surface. The recessed regions 204 may be etched inside the JTE 202, e.g., using dry etching. The N+ layer 206 may be segmented by etching.

Similar to the N+ implant 106 being present at the top surface in the example of Fig. 1, in the example of Fig. 2 the multiple N+ implants 206, 207 may be present at the top surface and at the top surface of the stopper area 208.

The multiple N+ implants 206, 207 may be formed by using multiple implantation steps with increasing dose and energy producing a graded doping profile with decreasing doping from the surface to the bottom of the JTE 202.

In the example of Fig. 2, two N type implanted regions are created at the top of JTE 202, the first 206 on the top side is with higher doping while the second 207 towards the end of JTE 202 is with a reduced doping level.

In an example, the first surface region 206 may have a doping of around 1E18 cm-3 to 1E20 cm-3 and a depth of 0.1 um to 0.3um while the second deeper region 207 may have a doping of around 1E17 cm-3 to 1E19 cm-3 and a depth of 0.2um to 0.4um.

Compared to Fig. 1, the graded doping profile as a result of having multiple N+ implants 206, 207 at the top surface may help to further reduce the electrical field at the JTE surface and at the corner of the recessed regions. Moreover, the graded doping profile may be beneficial to reduce the implantation damage at the bottom of the recessed region 204, which is typically highly defective due to the etching process used to form the recessed areas.

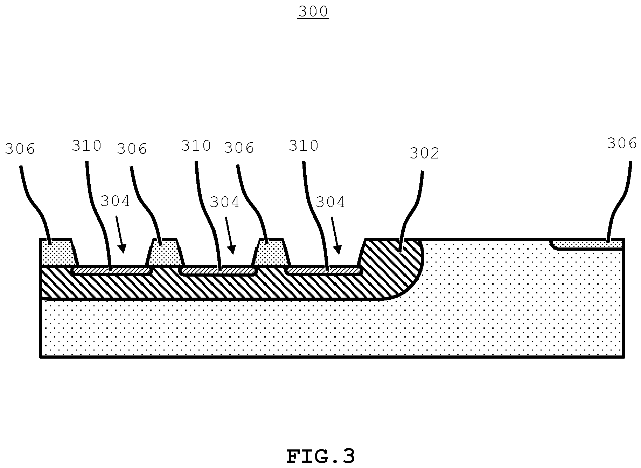

Fig. 3 shows an example embodiment of a semiconductor body 300, including a P type doped JTE 302 with recessed regions 304, with an N+ implant 306 at the top surface, and with a P-compensation implant 310 at the bottom of the recessed regions 304. The semiconductor body 300 is similar to the semiconductor body 100 of Fig. 1, with the addition of the P-compensation implant 310 at the bottom of the recessed regions 304.

In another example embodiment (not shown), a P-compensation implant similar to the P-compensation implant 310 may be applied to semiconductor body 200 of Fig. 2.

The P-compensation layer 310 may be used to balance residual doping from any implant tail. In an example, the P-compensation implant 310 may have a doping around the JTE doping + 10%.

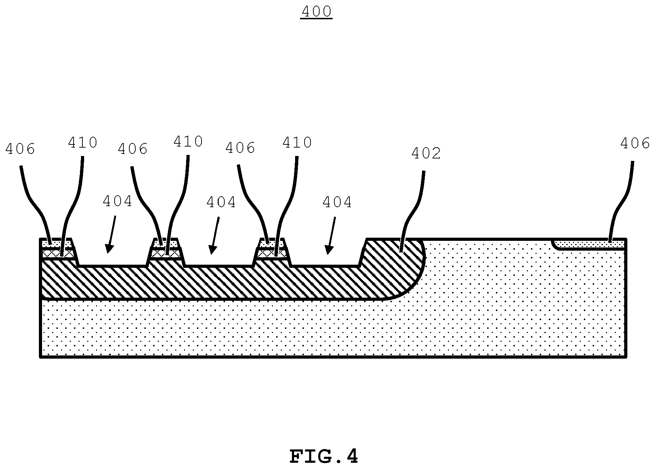

Fig. 4 shows an example embodiment of a semiconductor body 400, including a P type doped JTE 402 with recessed regions 404, with an N+ implant 406 at the top surface, and with a P-compensation implant 410 on the JTE 402 and below the N+ implant 406. The semiconductor body 400 is similar to the semiconductor body 100 of Fig. 1, with the addition of the P-compensation implant 410 on the JTE 402 and below the N+ implant 406, forming part of the recessed regions.

The semiconductor body 400 may include a P+ layer 410 on the JTE 402 surface under N+-regions 406. The P+ layer 410 results in a sharper doping transition to the N+ layer 406 and may be beneficial for very fine lateral dimensions of the N+ regions 406 since the PN junction can be triggered easier.

The P+ layer 410 may be defined by implantation. In an example, the P+ layer 410 has a doping between 1E18cm-3 and 1E20cm-3, preferably 1E19cm-3, and a depth between 0.2um and 0.4um, preferably 0.3um.

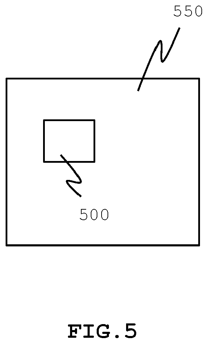

The present disclosure may advantageously be used in semiconductor devices, such as Power Devices (Schottky, PN and MPS Diodes, Mosfets, JFET), and in particular in such semiconductor devices including wide band gap semiconductor materials like SiC or Gallium nitride (GaN). Fig. 5 shows an abstract representation of an implementation of a semiconductor body 500, such as semiconductor body 100, 200, 300 or 400, in a semiconductor device 550.

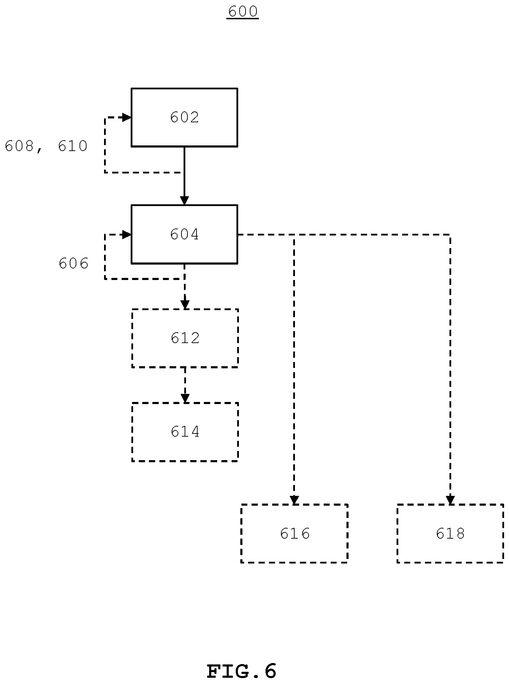

Fig. 6 shows an example embodiment of a method 600 of manufacturing a semiconductor device, such as the semiconductor device 550. Dashed boxes and dashed lines depict optional steps.

In step 602, the one or more recessed regions 104, 204, 304, 404 may be formed in the P doped Junction Termination Extension, JTE, implant 102, 202, 302, 402 of the semiconductor body 100, 200, 300, 400, 500. The depth of the recessed regions may be smaller than a depth of the JTE implant. In an example embodiment, the depth of the recessed regions may be smaller than half of the depth of the JTE implant.

In step 604, the N+ implant 106, 206, 306, 406 may be formed at the top surface of the JTE implant, such that the N+ implant forms a part of mesa regions in between the recessed regions. In an example embodiment, the N+ implant may be formed by an ion implantation or during epitaxy.

With step 606, multiple N+ implants, e.g., two N+ implants, may be formed at the top surface of the JTE implant with decreasing doping from the top surface of the JTE implant downwards. In an example embodiment, the multiple N+ implants may be formed using multiple implantation steps with increasing dose and energy, producing a graded doping profile with the decreasing doping from the top surface of the JTE implant downwards.

With step 608, multiple recessed regions may be formed having a substantially constant width and a substantially constant spacing. Alternatively, with step 610, multiple recessed regions may be formed having a spacing that increases along the JTE implant from an active area up to an outer edge of a termination.

In step 612, a further recessed region may be etched outside of the JTE implant and near a die edge. The further recessed region may be etched during the same process 602, 608, 610 used for forming the recessed regions in the JTE.

In step 614, an N+ implant may be formed at a top of the further recessed region during the same process 604 used for forming the N+ implant at the top of the JTE implant.

In step 616, P-compensation implants may be formed at a bottom of the recessed regions.

In step 618, a P+ implant may be formed at a top surface of the JTE implant and below the N+ implant, such that the P+ implant forms a part of the mesa regions in between the recessed regions.

It will be understood that steps may be performed in a different order, depending on the production process of the semiconductor body.

## Claims

1. A method (600) of manufacturing a semiconductor device, comprising:
forming (602) one or more recessed regions in a P doped Junction Termination Extension, JTE, implant of a semiconductor body, such that a depth of the recessed regions is smaller than a depth of the JTE implant; and
forming (604) an N+ implant at a top surface of the JTE implant, such that the N+ implant forms a part of mesa regions in between the recessed regions.

2. The method according to claim 1, wherein the depth of the recessed regions is smaller than half of the depth of the JTE implant.

3. The method according to any one of the preceding claims, wherein the method comprises forming the N+ implant by one of an ion implantation or during epitaxy.

4. The method according to any one of the preceding claims, wherein the method comprises forming (606) multiple N+ implants at the top surface of the JTE implant with decreasing doping from the top surface of the JTE implant downwards.

5. The method according to claim 4, wherein the method comprises forming the multiple N+ implants using multiple implantation steps with increasing dose and energy, producing a graded doping profile with the decreasing doping from the top surface of the JTE implant downwards.

6. The method according to any one of the claims 1-5, wherein the method comprises forming (608) multiple recessed regions having a substantially constant width and a substantially constant spacing.

7. The method according to any one of the claims 1-6, wherein the method comprises forming (610) multiple recessed regions having a spacing that increases along the JTE implant from an active area up to an outer edge of a termination.

8. The method according to any one of the preceding claims, further comprising etching (612) a further recessed region outside of the JTE implant and near a die edge, wherein the further recessed region is etched during the same process used for forming the recessed regions in the JTE.

9. The method according to claim 8, further comprising forming (614) an N+ implant at a top of the further recessed region during the same process used for forming the N+ implant at the top of the JTE implant.

10. The method according to any one of the preceding claims, wherein the method further comprises forming (616) P-compensation implants at a bottom of the recessed regions.

11. The method according to any one of the preceding claims, wherein the method further comprises forming (618) a P+ implant at a top surface of the JTE implant and below the N+ implant, such that the P+ implant forms a part of the mesa regions in between the recessed regions.

12. A semiconductor device (550) comprising a semiconductor body (100, 200, 300, 400, 500), wherein the semiconductor body comprises:
one or more recessed regions (104, 204, 304, 404) in a P doped Junction Termination Extension, JTE, region (102, 202, 302, 402), wherein a depth of the recessed regions is smaller than a depth of the JTE region; and
an N+ implant (106, 206, 306, 406) at a top surface of the JTE region, such that the N+ implant forms a part of mesa regions in between the recessed regions.

13. The semiconductor device according to claim 12, comprising multiple N+ implants (206, 207) at the top surface of the JTE implant with decreasing doping from the top surface of the JTE region downwards.

14. The semiconductor device according to any one of the claims 12-13, wherein the semiconductor body further comprises P-compensation implants (310) at a bottom of the recessed regions.

15. The semiconductor device according to claim 12 created using the method according to any one of the claims 1-11.
